**Europäisches Patentamt**

**European Patent Office**

**Office européen des brevets**

(11) Veröffentlichungsnummer: **0 008 394**
**B1**

## (12) EUROPÄISCHE PATENTSCHRIFT

(45) Veröffentlichungstag der Patentschrift:
23.02.83

(21) Anmeldenummer: 79102769.1

(22) Anmeldetag: 02.08.79

(51) Int. Cl.³: **G 03 F 7/08**

(54) Verfahren zum Entwickeln von belichteten lichtempfindlichen Druckplatten auf Basis von o-Naphthochinondiaziden.

(30) Priorität: 10.08.78 DE 2834958

(43) Veröffentlichungstag der Anmeldung:
05.03.80 Patentblatt 80/5

(45) Bekanntmachung des Hinweises auf die Patenterteilung:
23.02.83 Patentblatt 83/8

(84) Benannte Vertragsstaaten:
AT BE CH DE FR GB IT NL SE

(56) Entgegenhaltungen:
DE-A-1 621 478
DE-A-2 504 130
DE-B-1 193 366
DE-B-1 200 133
FR-A-2 211 674
GB-A-772 112

(73) Patentinhaber: **HOECHST AKTIENGESELLSCHAFT,
Postfach 80 03 20, D-6230 Frankfurt/Main 80 (DE)**

(72) Erfinder: **Berghäuser, Günter, Schönaustrasse 58,
D-6200 Wiesbaden (DE)**
Erfinder: **Hackmann, Ernst-August Dr.,
Grossglocknerstrasse 47, D-6200 Wiesbaden (DE)**
Erfinder: **Stahlhofen, Paul, Dr.,
Walter-Gieseking-Strasse 28, D-6200 Wiesbaden (DE)**

ACTORUM AG

Verfahren zum Entwickeln von belichteten lichtempfindlichen Druckplatten auf Basis von
o-Naphthochinondiaziden

Die Erfindung betrifft ein Verfahren zum Entwickeln von belichteten lichtempfindlichen Druckplatten mit einem Schichtträger aus anodisch oxydiertem Aluminium und einer lichtempfindlichen Schicht, die ein o-Naphthochinondiazid und ein alkaliölisliches Harz enthält.

Druckplatten der angegebenen Gattung werden im allgemeinen mit wässrig-alkalischen Lösungen, vorzugsweise Lösungen von Puffersalzen, entwickelt, wobei die belichteten Schichtbereiche im Entwickler gelöst werden.

In der DE-A 25 07 503 wird eine Lösung von Boraten und einwertigen Metallkationen zum Entwickeln derartiger Schichten beschrieben, die als Photoresistschichten dienen. Als Trägermaterial wird Kupfer angegeben.

Für die Entwicklung von Flachdruckplatten mit Schichtträgern aus Aluminium werden vorwiegend Lösungen von Alkaliphosphaten oder von Alkalisilikaten verwendet, wie es aus der DE-B 1 200 133 hervorgeht.

Für die Entwicklung von lichthärtbaren, also negativ arbeitenden Druckplatten, insbesondere solchen auf der Basis von Iminochinondiaziden, wird in der DE-B 1 193 366 eine entsprechende wässrig-alkalische Lösung beschrieben, die zusätzlich bestimmte mehrwertige Metallkationen und ggf. einen Komplexbildner enthält. Der Vorteil dieser Entwickler besteht in einem geringeren Angriff auf die lichtgehärtete Bildschablone. Als Trägermaterial für die zu entwickelnden Schichten wird metallisches Aluminium, Zink und Papierfolie angegeben.

In der DE-C 20 27 467 wird schliesslich die Verwendung von Entwicklerlösungen des zuletzt genannten Typs zur Entwicklung von belichteten photopolymerisierbaren Schichten beschrieben, die auf unterschiedliche Schichtträger aufgebracht sind, u.a. auf Aluminium, das gegebenenfalls anodisch oxydiert sein kann. Dabei wird über eine besondere Wirkung der Lösung bei bestimmten Schichtträgern nichts ausgesagt.

Die eingangs genannten, für die Entwicklung von Positivschichten bekannten Entwickler wurden auch für die in neuerer Zeit häufig verwendeten Flachdruckplatten auf anodisch oxydiertem Aluminium als Schichtträger verwendet, die wegen ihrer hohen Druckleistung bevorzugt werden. Dabei traten Schwankungen in der Qualität und Auflagenleistung der Druckformen auf, die zunächst nicht erklärt werden konnten.

Bei der Untersuchung dieses Problems wurde nun gefunden, dass diese Schwankungen mindestens zum Teil darauf zurückzuführen sind, dass die verwendeten Entwickler die anodisch erzeugte Oxidschicht angreifen und teilweise abtragen. Diese Erscheinung ist naturgemäss abhängig von der Konzentration bzw. dem pH der Entwicklerlösung, der Entwicklertemperatur und der Dauer der Einwirkung. Es zeigte sich aber auch, dass der Oxidangriff besonders ausgeprägt ist, wenn die Oxidschicht vor dem Aufbringen der lichtempfindlichen Schicht einer Vorbehandlung, z.B. mit Vinyl- oder Polyvinylphosphonsäuren, unterworfen worden ist.

Aus der FR-A 22 11 674 ist ferner eine Flachdruckplatte mit einem Schichtträger aus anodisch-oxidiertem Aluminium bekannt, die in der positiv- oder negativ-arbeitenden lichtempfindlichen Schicht ein Zn-, Cd-, Zr-, Ba-, Mg-, Al-, Sr-, Co- oder Mn-Salz enthält. Diese Platten sollen eine gute Lagerfähigkeit aufweisen und maschinell entwickelt werden können, ohne dass Probleme mit einem «Verschmieren» (Aufnahme von Druckfarbe in den Nichtbildstellen) auftreten würden.

In der DE-A 25 04 130 wird ein Verfahren zum Entwickeln von lichtempfindlichen Flachdruckplatten beschrieben, das bei erhöhter Temperatur von 35° bis 80°C und mit einem Entwickler arbeitet, dessen Komponenten über 80°C sieden. Als Entwicklerkomponenten werden alle gängigen organischen Lösemittel, Basen und Tenside, Wasser, verschiedenste Schaumverhinderer und unter den letztgenannten auch Mg- und Sr-Salze genannt. In den konkret durchgeführten Beispielen wurde keine Druckplatte eingesetzt, die einen anodisch-oxidierten Träger aus Aluminium und eine positiv-arbeitende lichtempfindliche Schicht trug.

Aufgabe der Erfindung war es, ein Entwicklungsverfahren für lichtempfindliche Druckplatten mit einem Schichtträger aus anodisiertem Aluminium und einer lichtempfindlichen Schicht, die ein o-Naphthochinondiazid und ein alkaliölisliches Harz enthält, bereitzustellen, bei dem die anodisch erzeugte Oxidschicht weniger stark angegriffen und dadurch eine höhere Druckauflage gewährleistet wird.

Die Erfindung geht aus von einem Verfahren zum Entwickeln von belichteten lichtempfindlichen Druckplatten mit einem Schichtträger aus anodisch oxydiertem Aluminium und einer lichtempfindlichen Schicht, die ein o-Naphthochinondiazid und ein alkaliölisliches Harz enthält, bei dem die belichteten Schichtbereiche mit einer wässrig-alkalischen Entwicklerlösung ausgewaschen werden.

Das erfindungsgemässe Verfahren ist dadurch gekennzeichnet, dass man die Entwicklung in Gegenwart einer der Entwicklerlösung zugesetzten ionisierbaren Verbindung eines Elements der II. oder III. Hauptgruppe oder der III. Nebengruppe des Periodensystems durchführt, wobei man eine Entwicklerlösung verwendet, die 0,001 bis 0,5 Gew.-% der ionisierbaren Verbindung enthält, vorzugsweise enthält die Entwicklerlösung 0,01 bis 0,3 Gew.-% der ionisierbaren Verbindung.

Die Löslichkeit der Verbindungen soll mindestens ausreichend sein, um die gewünschte Konzentration in den entsprechenden Lösungen zu erreichen. Als Zusatz zur Entwicklerlösung werden vorzugsweise wasserlösliche Salze, Oxide oder Hydroxide verwendet. Als ionisierbare Salze sind insbesondere die Halogenide, Sulfate, Nitrate, Formiate, Acetate, Propionate, Maleinate, Lactate, Lävulinate, Malonate, Adipate oder Fumarate geeignet. Besonders bevorzugt werden die ionisierbaren Verbindungen des Calciums, Strontiums oder Bariums.

Zur Erhöhung der Löslichkeit der ionisierbaren Verbindungen kann der Lösung eine kleine Menge eines Komplexbildners, z.B. einer organischen Verbindung, die mit den entsprechenden Kationen eine Chelatverbindung mit 5- oder 6-gliedrigem Ring zu bilden vermag, zugesetzt werden. Geeignete Komplexbildner sind Hydroxycarbonsäuren, Aminocarbonsäuren, enolisierbare Polycarbonylverbindungen, Hydroxy- oder Carboxylgruppen enthaltende Stickstoffverbindungen und Phenole. Beispiele für derartige Komplexbildner sind in der DE-B 1 193 366 angegeben.

Hauptbestandteil der wässrigen Entwicklerlösung sind in bekannter Weise alkalisch wirkende Substanzen, wie schwache oder starke anorganische oder organische Alkalien, z.B. Alkalisalze von schwachen oder mittelstarken Säuren, wie Wasserglas, Natriummetasilikat, sekundäres oder tertiäres Natrium- oder Kaliumphosphat; Basen, wie Natrium- oder Kaliumhydroxid, Diethylamin, Ethanolamin oder Triethanolamin. Diese alkalischen Verbindungen werden gegebenenfalls in einem Gemisch verwendet, in dem sie eine Pufferwirkung aufweisen. Ihre Menge wird so bemessen, dass das pH der Lösung im Bereich von etwa 10,5 bis 14, vorzugsweise von 12 bis 13,5, liegt. Besonders vorteilhaft sind die wasserlöslichen Alkalisilikate.

Die Entwicklerlösungen können weiterhin ionogene oder nichtionogene oberflächenaktive Verbindungen, Antischaummittel und wasserlösliche hochmolekulare Verbindungen zur Erhöhung der Viskosität enthalten, z.B. Polyglykole, Polyvinylalkohol oder Celluloseether.

Die Entwicklerlösung enthält als Lösungsmittel bevorzugt nur Wasser. Es ist jedoch möglich, in kleiner Menge, d.h. bis zu etwa 5 Gew.-%, organische, mit Wasser mischbare Lösungsmittel zuzusetzen.

Die nach dem erfindungsgemässen Verfahren zu entwickelnden Kopiermaterialien enthalten als lichtempfindliche Substanzen o-Naphthochinondiazide, insbesondere die Naphthochinon-(1,2)-diazid-(2)-sulfonsäureester oder -amide. Die lichtempfindlichen Schichten enthalten ferner alkalilösliche Harze, z.B. Phenolharze, Acryl- oder Methacrylsäuremischpolymerisate, Maleinsäuremischpolymerisate und andere Carboxylgruppen enthaltende Polymerisate. Bevorzugt werden Phenolharze, insbesondere Novolake.

Weitere mögliche Schichtbestandteile sind kleinere Mengen alkaliunlöslicher Harze, Farbstoffe, Weichmacher, Haftverbesserungsmittel und andere übliche Zusätze.

Als Schichtträger wird Aluminium verwendet, das eine anodisch erzeugte poröse Oxidschicht trägt. Das Aluminium wird zweckmässig vor dem Anodisieren mechanisch, chemisch oder elektrolytisch aufgerauht. Die Anodisierung erfolgt in bekannter Weise, z.B. in Schwefel- oder Phosphorsäure, vorzugsweise unter solchen Bedingungen, dass eine Oxidschicht mit einem Schichtgewicht von etwa 0,5 bis 10 g/m$^2$ erhalten wird. Die Stärke der Oxidschicht richtet sich im Einzelfall nach dem gewünschten Verwendungszweck. Durch das erfindungsgemässe schonende Entwicklungsverfahren ist es möglich, mit geringeren Oxidschichtdicken auszukommen und dadurch Zeit und Kosten zu sparen.

Vorteilhaft wird die Oxidschicht vor dem Aufbringen der lichtempfindlichen Schicht einer Vorbehandlung zur Verbesserung der Hydrophilie, z.B. mit einer Vinylphosphonsäure, insbesondere Polyvinylphosphonsäure, unterworfen, wie sie z.B. in der DE-C 16 21 478 beschrieben ist.

Durch die Erfindung wird erreicht, dass bei der Entwicklung des beschriebenen Kopiermaterials die Oxidschicht in erheblich geringerem Masse angegriffen wird als bei der Verwendung von sonst gleichen Entwicklerlösungen, die nicht die oben beschriebenen ionisierbaren Verbindungen enthalten. Dieser Vorteil macht sich insbesondere bei Schichtträgern bemerkbar, deren Oxidschicht in der angegebenen Weise vorbehandelt worden ist. Das Verfahren ist mit besonderem Vorteil bei der Entwicklung in automatischen Entwicklungsvorrichtungen anzuwenden, wo eine unterschiedlich starke Behandlung von grösseren bildfreien Stellen und Stellen mit grösserer Bilddeckung nicht möglich ist. Auch macht sich hier als Vorteil besonders bemerkbar, dass der Entwickler länger gebrauchsfähig bleibt, weil er in geringerem Masse durch abgetragenes Aluminiumoxid verunreinigt wird.

Die Erfindung wird an Hand der nachfolgenden Beispiele erläutert, in denen Gewichtsteile (Gt) und Volumteile (Vt) im Verhältnis von g zu ccm stehen. Prozente sind, wenn nichts anderes angegeben ist, Gewichtsprozente.

Beispiel 1
Man löst
0,76 Gt des Veresterungsproduktes aus 1 Mol 2,3,4-Trihydroxy-benzophenon und 3 Mol Naphthochinon-(1,2)-diazid-(2)-5-sulfonsäurechlorid,
0,58 Gt des Veresterungsproduktes aus 1 Mol 2,2'-Dihydroxy-dinaphthyl-(1,1')-methan und 2 Mol Naphthochinon-(1,2)-diazid-(2)-5-sulfonsäurechlorid,
0,19 Gt Naphthochinon-(1,2)-diazid-(2)-4-sulfonsäurechlorid,
5,85 Gt eines Kresol-Formaldehyd-Novolaks mit einem Erweichungspunkt von 105–120°C,
0,07 Gt Kristallviolett
in einem Lösungsmittelgemisch aus

40 Gt Ethylenglykolmonomethylether,
50 Gt Tetrahydrofuran,
10 Gt Butylacetat.

Mit dieser Lösung beschichtet man eine elektrolytisch aufgerauhte und anodisierte Aluminiumplatte mit einem Oxidgewicht von 3,20 g/m$^2$.

Der anodisierte Aluminium-Träger wurde vor dem Aufbringen der lichtempfindlichen Kopierschicht mit einer wässrigen Lösung von Polyvinylphosphonsäure behandelt, wobei ein Schichtgewicht von 0,02 g/m² erhalten wurde.

Das so hergestellte vorsensibilisierte Material wurde unter einer transparenten Positiv-Vorlage bildmässig belichtet und anschliessend mit der folgenden Lösung entwickelt:

0,58 Gt Natriumhydroxid,
4,86 Gt Natriummetasilikat · 9 Wasser,
1,00 Gt Polyglykol 200,
0,20 Gt Aluminiumsulfat,
100,00 Gt vollentsalztes Wasser.

Durch die Entwicklung werden die vom Licht zersetzten Anteile der Kopierschicht entfernt, und es bleiben die unbelichteten Bildstellen auf dem Schichtträger zurück, wobei man die der Vorlage entsprechende (positive) Druckschablone erhält. Von der so hergestellten Druckform können in einer Offsetmaschine etwa 200 000 einwandfreie Drucke hergestellt werden.

Das unterschiedliche Verhalten dieses Entwicklers gegenüber einem sonst gleichen Entwickler, jedoch ohne den Zusatz von Aluminiumsulfat, wird besonders deutlich, wenn man die entsprechend Beispiel 1 hergestellte lichtempfindliche Druckplatte nach der bildmässigen Belichtung verschieden lang den beiden Entwicklerlösungen aussetzt. Wird die bildmässig belichtete Druckform in einer Schaukelapparatur mit der Entwicklerlösung ohne den Zusatz der Aluminiumverbindung bei etwa 23°C behandelt, so ist bereits nach 5 Minuten an diskreten Stellen der nicht bebilderten Trägeroberfläche ein Oxidangriff festzustellen. Nach 10 Minuten ist schliesslich ein grossflächiger Oxidangriff deutlich sichtbar, wobei die ursprünglich grau erscheinende Oxidoberfläche des anodisierten Trägers an den bildfreien Stellen sich aufgehellt und mit einem weissen Belag überzogen hat.

Behandelt man dagegen die bildmässig belichtete Druckform unter gleichen Versuchsbedingungen mit der oben angegebenen Entwicklerlösung, d.h. in Gegenwart von Aluminium-Ionen, so ist selbst nach 20 Minuten Einwirkung an den bildfreien Stellen nur ein sehr geringer Oxidangriff festzustellen.

Beispiel 2

Eine wie in Beispiel 1 hergestellte Druckplatte wird nach der bildmässigen Belichtung unter einem Diapositiv mit einer Lösung folgender Zusammensetzung in bekannter Weise entwickelt:

7,20 Gt Natriummetasilikat · 9 H₂O,
0,02 Gt des Natriumsalzes eines Fettalkoholpolyglykolether-schwefelsäureesters,
0,01 Gt eines handelsüblichen Antischaummittels (Antifoam 60),
0,03 Gt Strontiumhydroxid,
0,06 Gt Lävulinsäure,
92,68 Gt vollentsalztes Wasser.

Von der so erhaltenen Druckform können in einer Offsetdruckmaschine etwa 250 000 einwandfreie Drucke hergestellt werden.

Nach einer Einwirkung dieses Entwicklers von 15 Minuten bei 23°C auf die belichtete Druckplatte ist kein Oxidabtrag festzustellen. Enthält die oben angegebene Entwicklerlösung dagegen keine Strontiumionen, so resultiert unter vergleichbaren Versuchsbedingungen ein starker Oxidabtrag (ca. 44 Gew.-%) an den bildfreien Stellen. Bemerkenswert ist ferner der Angriff der Druckschablone, besonders auffällig sichtbar an den sogenannten Halbtonstufen eines mitbelichteten Halbton-Stufenkeils. In Gegenwart der erfindungsgemäss dem Entwickler zugesetzten Strontiumionen ist dagegen dieser Angriff an dem Stufenkeil nicht mehr zu erkennen.

Beispiel 3

Eine wie in Beispiel 1 hergestellte Druckplatte wird nach der bildmässigen Belichtung unter einem Diapositiv mit einer Lösung entwickelt, die

36 Gt Natriummetasilikat · 9 H₂O,
0,1 Gt des in Beispiel 2 angegebenen anionischen Netzmittels,
0,05 Gt eines Antischaummittels,
464 Gt vollentsalztes Wasser,
und 1,5 Gt einer Lösung von
1,0 g Lävulinsäure und
0,3 g Calciumhydroxid in
15 ccm Wasser

enthält. Dies entspricht einem Gehalt von ca. 3,5 mg Ca⁺⁺ in 100 ccm Entwicklerlösung.

Die Hydrophilie des Hintergrunds der so enthaltenen Druckform in der Druckmaschine ist ausgezeichnet.

Wird die Druckplatte oder das nicht sensibilisierte Trägermaterial 15 Minuten in der oben angegebenen Entwicklerlösung gebadet, tritt keine sichtbare Veränderung der Aluminiumoberfläche ein.

Eine entsprechende Entwicklerlösung ohne den Zusatz von Ca⁺⁺-Ionen führt dagegen in der gleichen Zeit infolge chemischen Angriffs zu einem kreidigen, weissen Belag auf der Oberfläche des Aluminiums.

In den folgenden Beispielen 4–7 wird in entsprechender Weise wie in den Beispielen 1 und 2 verfahren, und es werden nach dem Belichten und Entwickeln der erhaltenen lichtempfindlichen Druckplatten ähnliche Resultate erhalten. Es werden daher für die folgenden Beispiele, soweit erforderlich, nur die Rezepturen der Beschichtungslösungen, die Art des verwendeten anodisierten Trägers und die Zusammensetzung der entsprechenden Entwicklerlösung angegeben.

Beispiel 4

Eine wie in Beispiel 1 hergestellte Druckform wird nach der bildmässigen Belichtung unter einem Diapositiv mit einer Lösung folgender Zusammensetzung in bekannter Weise entwickelt:

4,5 Gt Natriummetasilikat · 9 $H_2O$,
0,5 Gt Natriumhydroxid,
0,5 Gt Bor-III-oxid,
95,0 Gt vollentsalztes Wasser.

Beispiel 5
Zur Herstellung der Beschichtungslösung löst man

1,20 Gt des Veresterungsproduktes aus 1 Mol des Ethoxyethylesters der 4,4-Bis-(4-hydroxyphenyl)-n-valeriansäure und 2 Mol Naphthochinon-(1,2)-diazid-(2)-5-sulfonsäurechlorid,
6,00 Gt des in Beispiel 1 angegebenen Novolaks,
0,19 Gt Naphthochinon-(1,2)-diazid-(2)-4-sulfonsäurechlorid,
0,07 Gt Kristallviolett

in einem Lösungsmittelgemisch aus

40 Gt Ethylenglykolmonomethylether und
50 Gt Tetrahydrofuran.

Mit dieser Lösung beschichtet man eine elektrolytische aufgerauhte und anodisierte Aluminiumplatte entsprechend Beispiel 1. Nach der bildmässigen Belichtung unter einem Diapositiv wird die Druckform mit einem Entwickler der folgenden Zusammensetzung entwickelt:

2,50 Gt Natriumhydroxid,
22,50 Gt Natriummetasilikat · 9 Wasser,
1,00 Gt Lävulinsäure,
0,25 Gt Bariumchlorid,
475,00 Gt vollentsalztes Wasser.

Beispiel 6
Zur Herstellung der Beschichtungslösung löst man

1,00 Gt des 4-($\alpha,\alpha$-Dimethyl-benzyl)-phenylesters der Naphthochinon-(1,2)-diazid-(2)-5-sulfonsäure,
0,49 Gt des Veresterungsproduktes aus 1 Mol 2,2'-Dihydroxy-dinaphthyl-(1,1')-methan und 1 Mol Naphthochinon-(1,2)-diazid-(2)-5-sulfonsäurechlorid,
0,21 Gt Naphthochinon-(1,2)-diazid-(2)-4-sulfonsäurechlorid,
0,07 Gt Kristallviolettbase,
5,80 Gt des in Beispiel 1 angegebenen Novolaks

in einem Lösungsmittelgemisch aus

35 GT Ethylenglykolmonomethylether,
45 Gt Tetrahydrofuran,
10 Gt Butylacetat.

Mit dieser Lösung beschichtet man eine elektrolytisch aufgerauhte und anodisierte Aluminiumplatte mit einem Oxidgewicht von 3,30 g/m². Nach der bildmässigen Belichtung unter einem Diapositiv wird die Druckform mit einem Entwickler der folgenden Zusammensetzung aufentwickelt:

2,90 Gt Natriumhydroxid,
24,25 Gt Natriummetasilikat · 9 Wasser,
5,00 Gt Polyglykol 200,
0,50 Gt Strontiumchlorid · 6 Wasser,
1,00 Gt Lävulinsäure,
475,00 Gt vollentsalztes Wasser.

Beispiel 7
Eine wie in Beispiel 1 hergestellte Druckplatte wird nach der bildmässigen Belichtung unter einem Diapositiv mit einer Lösung folgender Zusammensetzung entwickelt:

7,20 Gt Natriummetasilikat · 9 Wasser,
0,02 Gt des in Beispiel 2 angegebenen anionischen Netzmittels,
0,01 Gt eines Antischaummittels,
0,20 Gt Lanthanchlorid,
92,60 Gt vollentsalztes Wasser.

Beispiel 8
Eine elektrochemisch aufgerauhte und anodisierte Aluminiumdruckplatte, die mit der gleichen lichtempfindlichen Schicht wie in Beispiel 6 versehen ist, wird nach der Belichtung unter einem Positivfilm in einer handelsüblichen Entwicklungsmaschine entwickelt. In den beiden Entwicklerwannen befinden sich 15 bzw. 5 Liter der untenstehenden Lösung. In der letzten Wanne ist eine 1%ige Lösung von Phosphorsäure in vollentsalztem Wasser enthalten. Die Lösungen werden mittels Düsen auf die zu entwickelnde Druckplatte gesprüht und laufend umgepumpt.

Entwicklerlösung:
0,58 Gt Natriumhydroxid,
4,86 Gt Natriummetasilikat · 9 Wasser,
1,00 Gt Polyglykol 200,
0,007 Gt Strontiumchlorid · 6 Wasser,
100,00 Gt vollentsalztes Wasser.

Durch die Entwicklung erhält man eine der Vorlage entsprechende Druckform. Das Oxidgewicht der ursprünglichen – noch nicht entwickelten – Aluminiumdruckplatte beträgt 2,74 g/m². Nach einem Durchgang durch die Maschine beträgt das Oxidgewicht an den bildfreien Stellen 2,52 g/m² = 92% und nach 3 Durchgängen noch 2,16 g/m² = 79% des ursprünglichen Wertes. Ohne Strontiumchlorid in der Entwicklerlösung ist der Oxidabtrag wesentlich höher. Nach 3 Maschinendurchgängen werden Druckplatten erhalten, die nur noch 60–55% des ursprünglichen Oxidgewichts aufweisen.

**Patentansprüche**

1. Verfahren zum Entwickeln von belichteten lichtempfindlichen Druckplatten mit einem Schichtträger aus anodisch oxydiertem Aluminium und einer lichtempfindlichen Schicht, die ein o-Naphthochinondiazid und ein alkalilösliches Harz enthält, bei dem die belichteten Schichtbereiche mit einer wässrig-alkalischen Entwicklerlösung ausgewaschen werden, dadurch gekennzeichnet, dass man die Entwicklung in Gegenwart einer der Entwicklerlösung zugesetzten ionisierbaren Verbindung eines Elements der II. oder III. Hauptgruppe oder der III. Nebengruppe des Periodensystems durchführt, wobei man eine Entwicklerlösung verwendet, die 0,001 bis 0,5 Gew.-% der ionisierbaren Verbindung enthält.

2. Verfahren nach Anspruch 1, dadurch gekennzeichnet, dass man als ionisierbare Verbindung eine Verbindung des Calciums, Strontiums oder Bariums verwendet.

3. Verfahren nach Anspruch 1, dadurch gekennzeichnet, dass man die ionisierbare Verbindung in Form von wasserlöslichen Salzen, Oxiden oder Hydroxiden verwendet.

4. Verfahren nach Anspruch 1, dadurch gekennzeichnet, dass man zusätzlich eine Verbindung verwendet, die zur Komplexbildung mit den Kationen der ionisierbaren Verbindung befähigt ist.

5. Verfahren nach Anspruch 1, dadurch gekennzeichnet, dass man eine Entwicklerlösung verwendet, die ein pH von 10,5 bis 14 hat.

6. Verfahren nach Anspruch 1, dadurch gekennzeichnet, dass die anodisch erzeugte Oxidschicht des Schichtträgers vor dem Aufbringen der lichtempfindlichen Schicht mit einer Lösung von Vinylphosphonsäure oder Polyvinylphosphonsäure behandelt worden ist.

## Claims

1. Process for the development of exposed light-sensitive printing plates having a support of anodically oxidized aluminum and a light-sensitive coating which contains an o-naphthoquinone-diazide and an alkali-soluble resin, the exposed areas of the coating being washed off with an aqueous-alkaline developer solution, characterized in that, the development is effected in the presence of an ionizable compound of an element of the groups IIa, IIIa or IIIb of the Periodic Table, which is added to the developer solution, and wherein the developer solution used contains 0.001 to 0.5% by weight of the ionizable compound.

2. A process as claimed in claim 1 wherein the ionizable compound used is a compound of calcium, strontium or barium.

3. A process as claimed in claim 1 wherein the ionizable compound is used in the form of watersoluble salts, oxides or hydroxides.

4. A process as claimed in claim 1 wherein additionally a compound is used which is capable of forming complexes with the cations of the ionizable compound.

5. A process as claimed in claim 1 wherein the developer solution used has a pH from 10.5 to 14.

6. A process as claimed in claim 1 wherein the anodically produced oxide layer of the support is pretreated with a solution of vinylphosphonic acid or polyvinyl phosphonic acid before applying the light-sensitive coating.

## Revendications

1. Procédé de développement de plaques d'impression photosensibles exposées comportant un support de couche en aluminium oxydé par voie anodique et une couche photosensible renfermant un o-naphtoquinone-diazide et une résine soluble dans l'alcali; selon lequel les zones de la couche exposées sont lavées avec une solution de développement aqueuse alcaline, caractérisé en ce que le développement est effectué en présence d'un composé ionisable, ajouté à la solution de développement, d'un élément du groupe principal II ou III ou du groupe III secondaire du système périodique, en utilisant une solution de développement contenant entre 0,001 et 0,5% en poids du composé ionisable.

2. Procédé selon la revendication 1, caractérisé en ce que l'on utilise comme composé ionisable un dérivé de calcium, de strontium ou de baryum.

3. Procédé selon la revendication 1, caractérisé en ce qu'on utilise le composé ionisable sous la forme de sels, oxydes ou hydroxydes hydrosolubles.

4. Procédé selon la revendication 1 caractérisé en ce qu'on utilise en outre un composé susceptible de former un complexe avec les cations du composé ionisable.

5. Procédé selon la revendication 1 caractérisé en ce que l'on emploie une solution de développement, ayant un pH entre 10,5 et 14.

6. Procédé selon la revendication 1, caractérisé en ce que la couche d'oxyde du support de couche est traitée avant l'application de la couche photosensible avec une solution d'acide vinylphosphonique ou polyvinylphosphonique.